# EUROPÄISCHE PATENTSCHRIFT

(11) **EP 2 371 062 B1**
(45) Veröffentlichungstag und Bekanntmachung des Hinweises auf die Patenterteilung: **09.01.2013**
(21) Anmeldenummer: 09748113.9
(22) Anmeldetag: 04.11.2009
(51) Int. Cl.: H03K 17/955, H03K 17/96, G01V 3/08, E05B 65/20

(54) **KAPAZITIVER ANNÄHERUNGSSENSOR MIT EINER SCHIRMELEKTRODE UND EINER DIAGNOSEELEKTRODE**
CAPACITIVE PROXIMITY SENSOR HAVING A SHIELDING ELECTRODE AND A DIAGNOSTIC ELECTRODE
CAPTEUR DE PROXIMITÉ CAPACITIF AVEC UNE ÉLECTRODE ÉCRAN ET UNE ÉLECTRODE DE DIAGNOSTIC

(30) Priorität: 25.11.2008 DE 102008044067
(43) Veröffentlichungstag der Anmeldung: 05.10.2011
(73) Patentinhaber: Huf Hülsbeck & Fürst GmbH & Co. KG, 42551 Velbert (DE)
(72) Erfinder: VAN GASTEL, Peter, 42699 Solingen (DE); BROZIO, Dieter, 45238 Essen (DE); LINDIC, Iko, 45149 Essen (DE)
(74) Vertreter: Zenz
(86) Internationale Anmeldenummer: PCT/EP2009/064643
(87) Internationale Veröffentlichungsnummer: WO 2010/060767

(56) Entgegenhaltungen:
- WO-A1-2009/044920
- DE-U1-202006 015 740
- US-A- 5 373 245
- US-A1- 2006 022 682

## Beschreibung

Die Erfindung betrifft eine kapazitive Annäherungssensoranordnung mit wenigstens einer beabstandet zu einer Massefläche angeordneten Sensorelektrode und einer zwischen der wenigstens einen Sensorelektrode und der Massefläche angeordneten Schirmelektrode und einer mit der wenigstens einen Sensorelektrode, der Schirmelektrode und mit Masse verbundenen Steuerschaltung, wobei die Steuerschaltung dafür sorgt, dass das Potenzial der Schirmelektrode dem Potenzial der wenigstens einen Sensorelektrode folgt, wobei die Steuerschaltung eine Messschaltung zum Messen der Kapazität der wenigstens einen Sensorelektrode gegenüber Masse aufweist. Ferner betrifft die Erfindung ein Verfahren zum Betreiben eines kapazitiven Annäherungssensors, der wenigstens eine beabstandet zu einer Massefläche angeordnete Sensorelektrode und eine zwischen der wenigstens einen Sensorelektrode und der Massefläche angeordnete Schirmelektrode aufweist und mit einer mit der wenigstens einen Sensorelektrode, der Schirmelektrode und mit Masse verbundenen Steuerschaltung gekoppelt ist, wobei das Potenzial der Schirmelektrode von der Steuerschaltung dem Potenzial der wenigstens einen Sensorelektrode nachgeführt wird, wobei die Kapazität der wenigstens einen Sensorelektrode gegenüber Masse von einer Messschaltung der Steuerschaltung gemessen wird.

Eine kapazitive Annäherungssensoranordnung der eingangs genannten Art wird beispielsweise als Sensoranordnung zum Erfassen der Annäherung eines Bedieners, insbesondere der Annäherung einer Hand des Bedieners, an einem Türgriff eines Kraftfahrzeugs zum Zwecke des Auslösens einer Abfrage eines von dem Bediener mitgeführten ID-Gebers (elektronischen Schlüssels) durch eine in dem Kraftfahrzeug angeordnete Steuereinheit verwendet. Eine derartige Sensoranordnung kann andererseits beispielsweise auch bei einer Einklemmschutzeinrichtung für eine von einem Antrieb bewegbare Tür oder Klappe Anwendung finden. Solche Anwendungen sowie eine kapazitive Annäherungssensoranordnung der eingangs genannten Art sind beispielsweise in der Veröffentlichung EP 1 164 240 A2 bzw. der Veröffentlichung DE 10 2006 044 778 A1 beschrieben.

Eine Messschaltung zum Messen der Kapazität einer Sensorelektrode gegenüber Masse bei einem solchen Annäherungssensor ist beispielsweise in der Patentschrift DE 196 81 725 B4 beschrieben.

Aus der DE 20 2006 015 740 U1 ist ein kapazitiver Sensor mit Messelektroden bekannt, die oberhalb einer als Massefläche ausgebildeten Gegenelektrode angeordnet sind. Zwischen den Messelektroden ist ferner eine Kalibrierelektrode vorgesehen, die auf ein Kalibrierpotenzial gelegt werden kann. Schließlich ist aus der US 5 373 245 A eine Anordnung einer Schirmelektrode zwischen einer Massefläche und einem Sensor bekannt.

Die Form und die Anordnung der Sensorelektrode (oder mehrerer Sensorelektroden) ist primär vom gewünschten Einsatzzweck des kapazitiven Annäherungssensors abhängig, insbesondere von den konstruktiven Gegebenheiten am Ort der Anordnung der Sensorelektrode, von der gewünschten Empfindlichkeit und von den am Einsatzort zu erwartenden Umgebungsbedingungen. Sofern ein derartiger Annäherungssensor in einem sicherheitsrelevanten Bereich eingesetzt wird, bei dem ein Ausfall oder ein Nicht-Funktionieren der Sensoranordnung zu einer Gefahrensituation für den Bediener führen kann, ist es erforderlich, die Funktionsfähigkeit der Sensoranordnung vor deren endgültigen Einsatz zu testen. Selbstverständlich könnte die Funktionsfähigkeit eines Sensors dadurch getestet werden, dass ein Objekt definierter Größe (welches ein Körperteil eines Bedieners simuliert) in vorgegebener Weise der installierten Sensoranordnung angenähert wird und das Ansprechen des Sensors überwacht und mit einer Sollfunktion verglichen wird. Eine solche Prüfanordnung ist allerdings relativ aufwendig und würde insbesondere beim Prüfen zahlreicher Sensoranordnungen in einer Großserienproduktion zu erheblichen Kosten führen.

Es ist deshalb eine Aufgabe der Erfindung, eine einfache Möglichkeit zum Überprüfen der Funktionsfähigkeit der Annäherungssensoranordnung ohne aufwändige Simulation der Annäherung eines Bedienerkörperteils zu schaffen, insbesondere eine einfache Überprüfungsmöglichkeit mit Hilfe einer programmgesteuerten Steuerelektronik zu schaffen, so dass die Überprüfung des Annäherungssensors in einen elektronisch gesteuerten Testablauf eingebunden werden kann.

Diese Aufgabe wird erfindungsgemäß durch eine kapazitive Annäherungssensoranordnung mit den Merkmalen des Anspruchs 1 gelöst. Insbesondere wird die Aufgabe bei einer kapazitiven Annäherungssensoranordnung der eingangs genannten Art dadurch gelöst, dass benachbart zu und beabstandet von der wenigstens einen Sensorelektrode sowie beabstandet von der Schirmelektrode eine Diagnoseelektrode angeordnet ist, und dass die Steuerschaltung in einem Normalbetriebsmodus die Diagnoseelektrode auf einem schwebenden Potenzial belässt und in einem Diagnosebetriebsmodus ein vorgegebenes Testpotenzial an die Diagnoseelektrode anlegt und eine sich daraus ergebende Änderung der gegenüber Masse gemessenen Kapazität der Sensorelektrode erfasst, wobei Anschlussleitungen und Widerstandsbauelemente derart mit der Sensorelektrode und der Diagnoseelektrode gekoppelt sind, dass eine mit der Steuerschaltung verbundene, die Elektroden einschließende Serienschaltung gebildet wird, deren Gesamtwiderstand von der Steuerschaltung erfasst werden kann.

Ferner wird die Aufgabe erfindungsgemäß durch ein Verfahren mit den Merkmalen des Anspruchs 9 gelöst. Erfindungsgemäß ist ein Verfahren der eingangs genannten Art dadurch gekennzeichnet, dass benachbart zu und beabstandet von der wenigstens einen Sensorelektrode sowie beabstandet von der Schirmelektrode eine Diagnoseelektrode angeordnet wird, wobei in einem Normalbetriebsmodus die Diagnoseelektrode auf einem schwebenden Potenzial belassen wird und in einem ersten Diagnosebetriebsmodus ein vorgegebenes Testpotenzial an die Diagnoseelektrode angelegt und eine sich daraus ergebende Änderung der gegenüber Masse gemessenen Kapazität der Sensorelektrode erfasst und mit einem Referenzwert verglichen wird, wobei die Sensorelektrode beziehungsweise wenigstens eine der Sensorelektroden an zwei beabstandeten Orten mit zwei mit der Steuerschaltung gekoppelten Anschlüssen versehen wird und in einem zweiten Diagnosebetriebsmodus der Widerstand zwischen den beiden Anschlüssen überprüft wird.

Durch dieses erfindungsgemäße Beaufschlagen der Diagnoseelektrode mit einem vorgegebenen Potenzial lässt sich auf einfache Weise die ordnungsgemäße Funktion des kapazitiven Annäherungssensors überprüfen. Die mit dem vorgegebenen Potenzial beaufschlagte Diagnoseelektrode simuliert dabei ein in den Erfassungsbereich des Annäherungssensors eindringendes Objekt.

Der Abstand der Diagnoseelektrode von der Sensorelektrode einerseits und der Schirmelektrode andererseits sowie die Ausbildung der Diagnoseelektrode selbst können in Abhängigkeit vom Einsatzgebiet stark variieren. Vorzugsweise sind die Diagnoseelektroden wie auch die Sensorelektroden als Platten oder Metallschichten ausgebildet, wobei Sensorelektrode und Diagnoseelektrode beispielsweise in einer Ebene angeordnet sind, welche in einem vorgegebenen Abstand vor der Schirmelektrode, welche die Sensorelektrode und die Diagnoseelektrode gegenüber Masse abschirmt, angeordnet sind. Bei anderen Ausführungsformen kann die Diagnoseelektrode auch teilweise oder vollständig überlappend über der Sensorelektrode angeordnet sein, so dass sich die Reihenfolge Masseebene, Schirmelektrode, Sensorelektrode und Diagnoseelektrode ergibt.

Bei einer bevorzugten Ausführungsform der erfindungsgemäßen kapazitiven Annäherungssensoranordnung entspricht das Testpotenzial Masse. Alternativ ist eine Ausführungsform denkbar, bei der das Testpotenzial einem Spannungsversorgungspotenzial oder einem konstanten, zwischen dem Spannungsversorgungspotenzial und Masse liegenden Zwischenpotenzial entspricht.

Bei einer Ausführungsform der Erfindung umfasst die Sensorelektrode wenigstens einen langgestreckten Metallstreifen (der sich beispielsweise entlang eines Türgriffs oder entlang einer Türöffnung erstreckt) und umfasst die Diagnoseelektrode einen zu dem wenigstens einen langgestreckten Metallstreifen parallelen Metallstreifen. Die beiden nebeneinander angeordneten Metallstreifen der Sensorelektrode und der Diagnoseelektrode können beispielsweise von gleicher Länge sein. Beispielsweise ist der Abstand zwischen dem Metallstreifen der Sensorelektrode und dem Metallstreifen der Diagnoseelektrode geringer als deren Breite. Bei einer alternativen Ausführungsform mit einer Sensorelektrode, die einen langgestreckten Metallstreifen umfasst, könnte die Diagnoseelektrode auch lediglich benachbart zu einem Endbereich des Metallstreifens der Sensorelektrode angeordnet sein, wobei der andere Endbereich des Metallstreifens der Sensorelektrode mit einer Anschlussleitung gekoppelt ist. Bei einer solchen Anordnung könnte die Stärke des Ansprechens beim Anlegen des vorgegebenen Potenzials an die Diagnoseelektrode einen Hinweis darauf geben, ob die Sensorelektrode an irgendeiner Stelle zwischen den beiden Endbereichen unterbrochen ist. Es ist auch denkbar, dass mehrere Diagnoseelektroden benachbart zu einer Sensorelektrode oder mehrere Sensorelektroden benachbart zu einer Diagnoseelektrode angeordnet sind.

Der Gesamtwiderstand der Serienschaltung aus Anschlussleitungen, Sensorelektrode, Widerstandsbauelement und Diagnoseelektrode gestattet eine Aussage über die bauliche Integrität der Elektroden. Sofern eine der Elektroden unterbrochen oder eine Anschlussleitung nicht richtig angekoppelt ist, kann dies sofort durch den stark erhöhten Gesamtwiderstand erfasst werden.

Vorzugsweise wird auch die Diagnoseelektrode an zwei beabstandeten Orten mit zwei Anschlüssen versehen und wird in dem zweiten Diagnosebetriebsmodus auch der Widerstand zwischen den beiden Anschlüssen der Diagnoseelektrode überprüft.

Bei einer bevorzugten Ausführungsform umfasst die Sensorelektrode einen langgestreckten Metallstreifen und ist die Diagnoseelektrode ein dazu paralleler Metallstreifen, wobei beide Metallstreifen in Längsrichtung in die Serienschaltung eingebunden sind. Vorzugsweise sind der Metallstreifen der Sensorelektrode und der parallele Metallstreifen der Diagnoseelektrode an einem Ende über ein Widerstandsbauelement miteinander verbunden und an dem jeweils anderen Ende mit den Anschlussleitungen versehen. Das Widerstandsbauelement sollte einen Widerstand haben, der hoch genug ist, um im Diagnosebetriebsmodus ein Ziehen der Sensorelektrode auf das fixe Potenzial der Diagnoseelektrode zu vermeiden, der aber nicht derart hoch ist, dass der von diesem Widerstandsbauelement maßgeblich bestimmte Gesamtwiderstand der Serienschaltung durch die Steuerschaltung nicht mehr vom Gesamtwiderstand der Serienschaltung bei unterbrochener Diagnoseelektrode oder unterbrochener Sensorelektrode bzw. nicht ordnungsgemäßem Anschluss unterscheidbar ist. Eine entsprechende bevorzugte Ausführungsform des erfindungsgemäßen Verfahrens ist dadurch gekennzeichnet, dass die Sensorelektrode bzw. wenigstens eine der Sensorelektroden langgestreckt ausgebildet und an ihren Enden mit je einem Anschluss versehen wird, dass die Diagnoseelektrode ebenfalls langgestreckt und parallel zu der Sensorelektrode ausgebildet und an ihren Enden mit je einem Anschluss versehen wird, dass die an einem der benachbarten Enden angeordneten Anschlüssen über ein Widerstandsbauelement miteinander verbunden und die anderen beiden Anschlüsse mit der Steuerschaltung gekoppelt werden und dass in dem zweiten Diagnosebetriebsmodus der Widerstand der Serienschaltung der Sensorelektrode, des Widerstandsbauelements und der Diagnoseelektrode überprüft wird. Eine solche Anordnung hat den Vorteil, dass eine langgestreckte kapazitive Sensoranordnung nur an einem Ende mit Anschlussleitungen zu versehen ist, was eine einfachere konstruktive Unterbringung gestattet. Das an dem anderen Ende vorgesehen Widerstandsbauelement kann ein diskretes Bauelement mit Anschlussleitungen oder auch ein Schichtwiderstandsbauelement sein.

Bei einer alternativen Annäherungssensoranordnung umfasst die Sensorelektrode zwei parallel nebeneinander angeordnete langgestreckte Metallstreifen und ist die Diagnoseelektrode ein dazwischen angeordneter, paralleler Metallstreifen, wobei wenigstens zwei der drei Metallstreifen in Längsrichtung in die Serienschaltung eingebunden sind. Beispielsweise sind einer der Metallstreifen der Sensorelektrode und der Metallstreifen der Diagnoseelektrode in Serie geschaltet. Alternativ ist es auch denkbar, dass die beiden Metallstreifen der Sensorelektrode in Serie geschaltet sind, wobei in diesem Fall die Integrität der Diagnoseelektrode nicht mit überprüft wird. Bei dem zuletzt genannten Fall sind die beiden parallelen Metallstreifen der Sensorelektrode an einem Ende über einen Widerstand oder auch eine Kurzschlussleitung miteinander verbunden, wobei an dem jeweils anderen Ende die Anschlussleitungen für die Steuerschaltung angekoppelt sind.

Bei einer bevorzugten Weiterbildung des erfindungsgemäßen Verfahrens wird der erste Diagnosebetriebsmodus (bei dem das Ansprechen der Sensorelektrode mit Hilfe der Diagnoseelektrode getestet wird) während einer Initialisierung aktiviert und wird ein Bezugswert abgespeichert, der der beim Anliegen des vorgegebenen Testpotenzials an der Diagnoseelektrode gegenüber Masse gemessenen Kapazität der Sensorelektrode entspricht. Während des nachfolgenden Betriebs wird der erste Diagnosebetriebsmodus wiederholt aktiviert, wobei dann der während der Initialisierung abgespeicherte Bezugswert mit einem Wert verglichen wird, der der beim Anliegen des vorgegebenen Testpotenzials an der Diagnoseelektrode gemessenen Kapazität der Sensorelektrode entspricht. Bei Überschreiten einer vorgegebenen Abweichung wird dann ein ein Aufliegen eines Objekts auf dem Annäherungssensor anzeigendes Signal erzeugt. Auf diese Weise ist es möglich, dass während des ersten Diagnosebetriebsmodus, der wiederholt in Intervallen während des Betriebs aktiviert wird, das statische Aufliegen beispielsweise einer Hand auf der Oberfläche des kapazitiven Annäherungssensors erfasst werden kann, was bei bekannten Annäherungssensoranordnungen durch eine ständig nachgeführte Kalibrierung (zum Vermeiden eines Ansprechens des Sensors bei Umgebungsänderungen langsamer Art) nicht ohne weiteres erfasst werden konnte.

Vorteilhafte und/oder bevorzugte Weiterbildungen der Erfindung sind in den Unteransprüchen gekennzeichnet.

Im Folgenden wird die Erfindung anhand von in den Zeichnungen dargestellten bevorzugten Ausführungsformen näher beschrieben. In den Zeichnungen zeigen:
Figur 1 eine schematische Perspektivdarstellung der Anordnung verschiedener Elektroden einer ersten Ausführungsform der erfindungsgemäßen Annäherungssensoranordnung;
Figur 2 eine schematische Perspektivdarstellung der Elektrodenanordnung einer zweiten Ausführungsform der erfindungsgemäßen Annäherungssensoranordnung;
Figuren 3A und 3B schematische Darstellungen zweier Betriebszustände der erfindungsgemäßen Annäherungssensoranordnung mit einer neben der Sensorelektrode angeordneten Diagnoseelektrode; und
Figur 4A und 4B zwei Betriebszustände einer alternativen Ausführungsform der erfindungsgemäßen Annäherungssensoranordnung mit einer über der Sensorelektrode angeordneten Diagnoseelektrode.

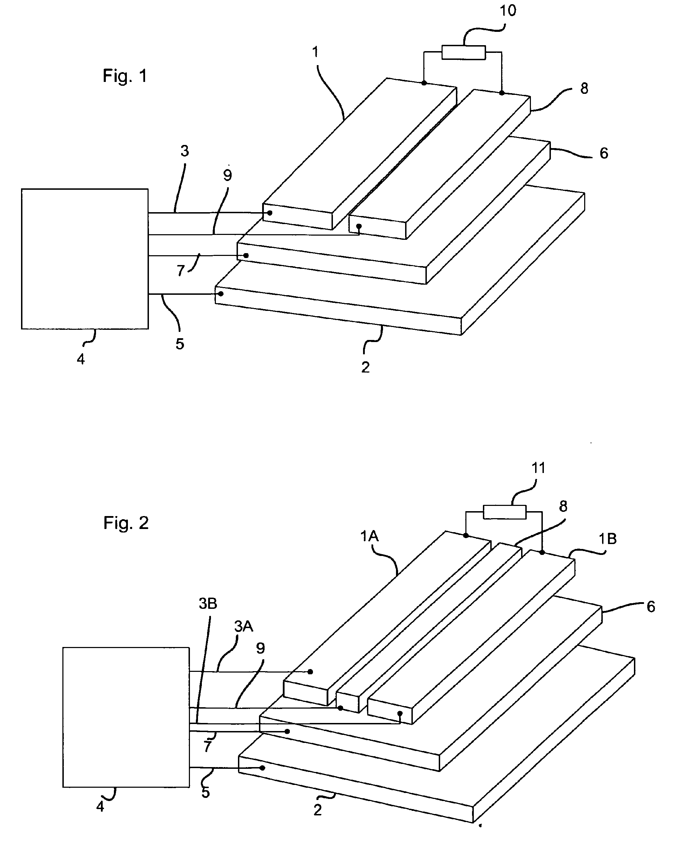

Figur 1 zeigte eine schematische Darstellung einer erfindungsgemäßen Annäherungssensoranordnung. Der kapazitive Annäherungssensor umfasst wenigstens eine Sensorelektrode 1, die beabstandet zu einer Massefläche 2 angeordnet ist. Die Sensorelektrode 1 und die Massefläche 2 sind in der schematischen Darstellung der Figur 1 als rechteckige Platten dargestellt. In der Praxis wird die Massefläche 2 von einer leitenden Oberfläche beliebiger Gestaltung, beispielsweise von einem Karosseriebauteil, oder auch von einer Metallisierungsebene einer Leiterplatte gebildet. Die Sensorelektrode 1 kann ebenfalls nahezu beliebige Formen annehmen. Vorzugsweise handelt es sich jedoch um eine Metallschicht, beispielsweise einer Leiterplatte, oder um ein in vorgegebener Weise geformtes Metallblech. Die Sensorelektrode 1 ist mit wenigstens einer Anschlussleitung 3 verbunden, welche die Sensorelektrode 1 mit einer Steuerschaltung 4 koppelt, wobei die Steuerschaltung 4, welche auch als Ansteuerelektronik bezeichnet wird, in Figur 1 als Block dargestellt ist. Die Steuerschaltung 4 enthält unter anderem eine Auswerteelektronik oder Messschaltung zum Bestimmen der Kapazität der Sensorelektronik gegenüber einer Masse. Die Steuerschaltung 4 ist bei der in Figur 1 schematisch dargestellten Ausführungsform über eine weitere Anschlussleitung 5 mit der Masse in Form der Massefläche 2 verbunden. Zwischen der Sensorelektrode 1 und der Masse ist eine bestimmte Kapazität messbar, die einerseits von Form und Anordnung der Sensorelektrode gegenüber der Massefläche 2 und andererseits sowohl von dem zwischen der Sensorelektrode 1 und der Massefläche 2 angeordneten Medium als auch von den sich in der Umgebung der Sensorelektrode 1 aufhaltenden Objekten abhängig ist. Wenn über die Anschlussleitungen 3 und 5 zwischen der Sensorelektrode 1 und der Massefläche 2 eine Spannung angelegt wird, so bildet sich zwischen der Sensorelektrode 1 und der Masse eine elektrisches Feld aus, welches normalerweise dort, wo die Sensorelektrode 1 den geringsten Abstand von der Massefläche 2 hat, seine höchste Dichte (höchste Feldstärke) annimmt. Das stärkste elektrische Feld würde sich direkt in dem Spalt zwischen der Sensorelektrode 1 und der Massefläche 2 ausbilden, und nur ein geringer Teil des elektrischen Feldes würde in den Umgebungsraum hineinreichen. Dieses wiederum würde bedeuten, dass Änderungen der sich im Raum befindenden Objekte einen relativ geringen Einfluss auf das elektrische Feld und somit die zwischen Sensorelektrode 1 und Massefläche 2 gemessene Kapazität haben würden. Um die Empfindlichkeit des kapazitiven Sensors zu erhöhen, wurde vorgeschlagen, zwischen der Sensorelektrode 1 und der Massefläche 2 eine Schirmelektrode 6 anzuordnen. Die Schirmelektrode 6 ist über eine Zuleitung 7 ebenfalls mit der Steuerschaltung 4 verbunden. Die Steuerschaltung 4 sorgt dafür, dass das Potenzial der Schirmelektrode 6 dem Potenzial der Sensorelektrode 1 nachgeführt wird, wobei aber die Sensorelektrode 1 nicht direkt mit der Schirmelektrode verbunden ist. Die Folge des Einsatzes einer solchen Schirmelektrode 6 mit entsprechender Ansteuerung ist dann, dass sich kein starkes elektrisches Feld mehr in dem Spalt zwischen Sensorelektrode 1 und Massefläche 2 ausbildet, sondern sich das Feld primär in den Raum oberhalb der Sensoranordnung hinein ausbreitet. Dies wiederum führt zu einer stärkeren Abhängigkeit der Feldstärke bzw. der Kapazität der gesamten Anordnung von den sich in dem Raum befindenden Objekten, das heißt zu einer höheren Empfindlichkeit des kapazitiven Annäherungssensors.

Die Steuerschaltung 4 enthält eine Messschaltung zum Messen der Kapazität der wenigstens einen Steuerelektrode 1 gegenüber der Massefläche 2. Um diese Kapazität zu messen, gibt es verschiedene Vorgehensweisen. Bei den meisten Verfahren wird eine sich ändernde Spannung zwischen der Sensorelektrode 1 und der Masse 2 angelegt, was wiederum bedeutet, dass das Potenzial der Schirmelektrode 6 ständig dem Potenzial der Sensorelektrode 1 nachgeführt werden muss. Die Vorgehensweisen beim Messen der Kapazität und beim Nachführen des Potenzials sind aus dem Stand der Technik bekannt, beispielsweise aus den Druckschriften EP 1 164 240 A2, EP 0 518 836 A1, DE 196 81 725 D4 oder DE 10 2006 044 778 A1. Die Messprinzipien und die Technik des Nachführens des Potenzials der Schirmelektrode sollen hier deshalb nicht näher beschrieben werden.

Ein solcher kapazitiver Annäherungssensor mit Schirmelektrode wird beispielsweise als Annäherungssensor zum Erfassen der Annäherung der Hand eines Bedieners an einen Türgriff oder bei Sensoren eingesetzt, welche erfassen, ob sich ein Objekt derart in einer Türöffnung befindet, dass es beim Schließen der Tür eingeklemmt werden kann. Insbesondere bei Systemen, bei denen ein fehlerhaftes Nicht-Erfassen des Objekts zu Sicherheitsproblemen führen kann, ist es erwünscht, die ordnungsgemäße Funktion des Sensors regelmäßig zu testen. Dies ist beispielsweise bei Schiebetüren, Heckklappen, Cabrioverdecken, Seitentüren, Schiebedächern oder Fensterhebern der Fall. Hier benötigt eine Steuerelektronik Aussagen darüber, ob der Sensor grundsätzlich funktioniert oder nicht.

Bei dem in Figur 1 schematisch dargestellten Ausführungsbeispiel ist deshalb erfindungsgemäß parallel zu der Sensorelektrode 1 eine Diagnoseelektrode 8 vorgesehen, die über eine weitere Anschlussleitung 9 mit der Steuerschaltung 4 gekoppelt ist. In einem normalen Betrieb ist die Diagnoseelektrode 8 inaktiv, indem sie beispielsweise auf schwebendem Potenzial belassen wird oder indem sie über die Steuerschaltung 4 mit der Sensorelektrode 1 verbunden wird. Zumindest bei den Ausführungsformen (wie in Figur 1), bei denen die Diagnoseelektrode 8 im normalen Betriebsmodus mit der Sensorelektrode 1 verbunden wird, erstreckt sich die Schirmelektrode 6 auch unter die Diagnoseelektrode 8.

Soll ein Funktionstest des kapazitiven Sensors mit der Steuerelektrode 1 ausgeführt werden, so wird die Diagnoseelektrode 8 auf ein konstantes Potenzial, beispielsweise auf Masse, gelegt. Dann verhält sich die Diagnoseelektrode 8 wie ein in das Feld der Sensorelektrode 1 eindringendes, mit Masse gekoppeltes Objekt. Bei ordnungsgemäßer Funktion des kapazitiven Annäherungssensors muss dies zu einem das Eindringen eines Objekts anzeigenden Ausgabesignal führen. Wird ein solches Ausgabesignal erfasst, so kann von einer ordnungsgemäßen Funktion der Sensoranordnung ausgegangen werden.

Die zu diesem Diagnosezweck kurzzeitig auf Masse gelegte Diagnoseelektrode 8 kann sich bei einem Ausführungsbeispiel parallel zu einer streifenförmigen Sensorelektrode 1 erstrecken. Bei anderen Ausführungsformen kann sie an einer beliebigen Stelle benachbart zu der Sensorelektrode 1 angeordnet sein.

Bei einer parallel zu einer streifenförmigen Sensorelektrode 1 angeordneten Diagnoseelektrode 8 ist nicht feststellbar, ob die Sensorelektrode 1 quer zu ihrer Längserstreckung unterbrochen ist (beispielsweise durchgerissen), sofern noch eine ausreichende Kopplung zwischen dem mit der Zuleitung 3 geschalteten Rest der Sensorelektrode 1 und der Diagnoseelektrode 8 besteht. Deshalb ist bei dem in Figur 1 schematisch dargestellten Ausführungsbeispiel vorgesehen, dass die Sensorelektrode 1 und die Diagnoseelektrode 8, welche sich als parallele Streifen oberhalb der Schirmelektrode 6 erstrecken, an einem Ende mit den Anschlussleitungen 3 bzw. 9 mit der Steuerschaltung 4 und an dem entgegengesetzten Ende über ein Widerstandsbauelement 10 miteinander gekoppelt sind. Aus der Zuleitung 3, der Sensorelektrode 1, dem Widerstandsbauelement 10, der Diagnoseelektrode 8 und der Zuleitung 9 wird somit eine Schleife gebildet, deren Gesamtwiderstand von der Steuerschaltung 4 gemessen werden kann. Sofern der Widerstand in einem vorgegebenem Bereich liegt, der näherungsweise dem Widerstandswert des Bauelements 10 entspricht, kann sowohl von einer näherungsweise intakten Sensorelektrode 1 als auch von einer intakten Diagnoseelektrode 8 ausgegangen werden. Dieser Schleifenwiderstand wird wiederum in einem Diagnosebetriebsmodus von der Steuerschaltung 4 gemessen und ausgewertet.

In regelmäßigen Abständen kann während des Betriebs der Sensoranordnung einerseits das ordnungsgemäße Funktionieren des kapazitiven Sensors durch ein Beschalten der Diagnoseelektrode 8 mit Masse (Simulation des Eindringen eines Objekts) sowie andererseits die Unversehrtheit der Elektroden durch Messen des Schleifenwiderstands zwischen den Anschlussleitungen 3 und 9 überprüft werden. Es ist klar, dass während dieser Funktionstests reale Objekte außerhalb der Sensoranordnung nicht vom Sensor erfasst werden können. Deshalb wird dieser Test immer nur kurzzeitig in vorgegeben Abstände während des normalen Betriebs vorgenommen, beispielsweise beim Einschalten der Steuerschaltung, das heißt bei deren Initialisierung.

Die Dicken der in Figur 1 schematisch dargestellten Elektroden, die Abstände der Elektrodenflächen voneinander sowie der Abstand zwischen der Diagnoseelektrode 8 und der Sensorelektrode 1 hängen einerseits von der Herstellungstechnologie anderseits vom gewünschten Einsatzgebiet des Annäherungssensors ab. Beispielsweise ist der Abstand zwischen der Sensorelektrode 1 und der Diagnoseelektrode 8 geringer als deren Breite.

Der Widerstand des Widerstandsbauelements 10 muss relativ hoch sein, damit bei dem Funktionstest des Ansprechens des kapazitiven Sensors durch ein Auf-Masse-Legen der Diagnoseelektrode 8 keine die Kapazitätsmessung wesentlich beeinflussenden Ströme durch das Bauelement 10 fließen. Andererseits darf der Widerstand des Bauelements 10 nicht so groß sein, dass kein Schleifenwiderstand zwischen den Anschlüssen 3 und 9 mehr messbar wäre.

Figur 2 zeigt eine schematische Darstellung einer alternativen Ausführungsform, bei der eine Diagnoseelektrode 8 zwischen zwei parallel verlaufenden Sensorelektroden 1A und 1B angeordnet ist. Im normalen Betrieb wirken die beiden Sensorelektroden 1A und 1B zusammen, das heißt, sie sind miteinander verbunden, und es wird die Kapazität der miteinander verbundenen Sensorelektroden 1A und 1B gegenüber Masse 2 gemessen. Dabei liegt die Diagnoseelektrode 8 entweder wiederum auf einem schwebendem Potenzial oder ist ebenfalls mit den Sensorelektroden 1A und 1B verbunden. Auch bei der Diagnose der kapazitiven Sensorfunktion, bei der in einem ersten Diagnosebetriebsmodus die Diagnoseelektrode 8 von der Steuerschaltung 4 auf Masse gelegt wird und die sich daraus ergebende Änderung der Kapazität der Sensorelektroden 1A und 1B gegenüber Masse erfasst wird, bleiben die beiden Sensorelektroden 1a und 1b miteinander verbunden. Erst in einem weiteren, zweiten Diagnosebetriebmodus wird der Widerstand einer Schleife gemessen, die sich aus der Zuleitung 3A, der ersten Sensorelektrode 1A, dem Widerstandsbauelement 11, der zweiten Sensorelektroden 1B und der zweiten Zuleitung 3b zusammensetzt. Dabei sind die Anschlussleitungen 3A, 3B und 9 an einem Ende der parallelen Streifenelektroden-Anordnung angekoppelt, während die Sensorelektroden 1A und 1B am entgegengesetzten Ende über das Widerstandsbauelement 11 miteinander gekoppelt sind. Das Widerstandsbauelement 11 kann hierbei einen sehr geringen Widerstand haben, so dass es als Kurzschluss zwischen den Enden der Sensorelektroden 1A und 1B wirkt.

Eine Weiterbildung der erfindungsgemäßen Annäherungssensoranordnung befasst sich mit dem Problem, welches sich dann ergibt, wenn ein mit Masse gekoppeltes Objekt, beispielsweise eine Hand des Bedieners, dauerhaft (d. h. für einen längeren Zeitraum) auf dem kapazitiven Sensor aufliegt. Dieses Problem tritt immer dann auf, wenn der Sensor so ausgebildet ist, dass seine Empfindlichkeit sich ändernden Umgebungsbedingungen nachgeregelt wird. Da der kapazitive Sensor grundsätzlich immer dann ein Ausgangssignal auslöst, wenn sich seine Kapazität ändert, und da eine Kapazitätsänderung einerseits dann auftritt, wenn sich ein zu erfassendes Objekt annähert, aber andererseits auch dann auftritt, wenn sich die Umgebungsbedingungen langsam ändern (beispielsweise eine höhere Feuchtigkeit der Umgebung auftritt), was nicht zu einem Ansprechen des Sensors führen soll, weisen derartige Sensoren üblicherweise eine Schaltung auf, die langsame Änderungen oder lang anhaltende Änderungen der Kapazität nicht erfassen, so dass der Sensor nur dann die Annäherung eines Objekts erfasst, wenn sich relativ kurzfristig die Kapazität um einen vorgegebenen Betrag ändert. Wenn beispielsweise eine Hand auf einen solchen Sensor aufgelegt wird, so wird zunächst die kurzzeitige Änderung der Kapazität durch das Annähern der Hand erfasst. Wenn dann aber die Hand auf den Sensor liegen bleibt und sich somit keine weitere Kapazitätsänderung ergibt, so geht die Auswerteschaltung nach einiger Zeit davon aus, dass kein Objekt auf dem Annäherungssensor vorhanden ist. Beispielsweise kann dies dazu führen, dass bei einem als Einklemmschutz dienenden Sensor die dauerhaft (d. h. länger) aufliegende Hand ignoriert wird, so dass ein anschließendes Schließen der überwachten Öffnung zu einem Einklemmen der Hand führen könnte. Es wäre also grundsätzlich wünschenswert, nicht nur kurzzeitige Änderungen der Kapazität in einem normalen Betrieb erfassen zu können, sondern darüber hinaus auch bestimmte Änderungen der Grundkapazität (absolute Änderungen). Dies wird erfindungsgemäß durch folgende Vorgehensweise erreicht.

Zunächst wird bei einer Initialisierung die Diagnoseelektrode 8 (wie auch beim Test der Sensoranordnung) auf Masse gelegt. Dann wird die dabei sich ausbildende Kapazität der Sensorelektrode 1 gegenüber Masse gemessen, die in diesem Fall im Wesentlichen von der Kapazität zwischen der Sensorelektrode 1 und der benachbarten, auf Masse liegenden Diagnoseelektrode 8 bestimmt wird. Ein diesem Kapazitätswert entsprechender Bezugswert wird während der Initialisierung für eine spätere Verwendung gespeichert.

Während des Betriebs des kapazitiven Annäherungssensors wird dann regelmäßig ein Diagnosemodus zum Erkennen eines aufliegenden Objekts (einer aufliegenden Hand) in den normalen Betrieb periodisch eingeschachtelt. Dabei wird die Diagnoseelektrode 8 wiederum auf Masse gelegt und der dann sich bildende Kapazitätswert zwischen der Sensorelektrode und Masse gemessen. Aufgrund des Umstands, dass der dann gemessene Kapazitätswert im Wesentlichen von der Kapazität zwischen Sensorelektrode 1 und Diagnoseelektrode 8 abhängt und nur im geringen Maße von dem sich nach außen ausbreitenden Streufeld, ist der so geschaltete Sensor relativ unempfindlich gegen sich annähernde, mit Masse gekoppelte Objekte. Wenn jedoch die Hand eines Bedieners unmittelbar dicht auf dem Sensorbereich aufliegt, so führt diese relativ starke Ankopplung einer weiteren Massefläche dennoch zu einer messbaren Kapazitätsänderung. Diese wird erfasst, indem der gemessene Kapazitätswert mit dem Wert des bei der Initialisierung gespeicherten Bezugswerts verglichen wird. Wenn die Differenz einen vorgegebenen Schwellwert überschreitet, so geht die Steuerelektronik davon aus, dass ein mit Masse gekoppeltes Objekt, insbesondere ein Körperteil des Bedieners auf dem Sensor aufliegt.

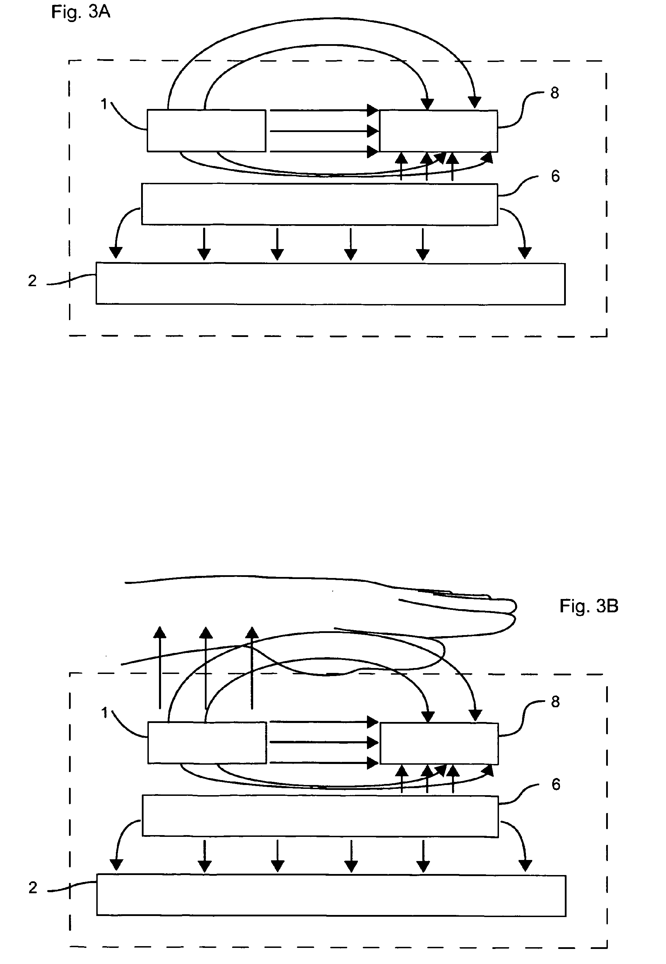

Figuren 3A und 3B zeigen schematisch einen Querschnitt durch die Sensoranordnung während des Diagnosemodus zum Erfassen des Aufliegens eines mit Masse gekoppelten Objekts, wobei Figur 3A die Anordnung ohne aufliegendes Objekt und die Figur 3B die Anordnung mit aufliegendem Objekt (aufliegende Hand) zeigt. Mit den Pfeilen sind Feldlinien, insbesondere zwischen der Sensorelektrode 1 und der Diagnoseelektrode 8 sowie zwischen der Schirmelektrode 6 und der Massefläche 2, angedeutet. Bei dem in den Figuren 3A und 3B dargestellten Ausführungsbeispiel ist die Diagnoseelektrode 8 neben der Sensorelektrode 1 angeordnet. Figur 3A stellt gleichzeitig schematisch diejenige Feldverteilung dar, die sich während des Initialisierens ergibt.

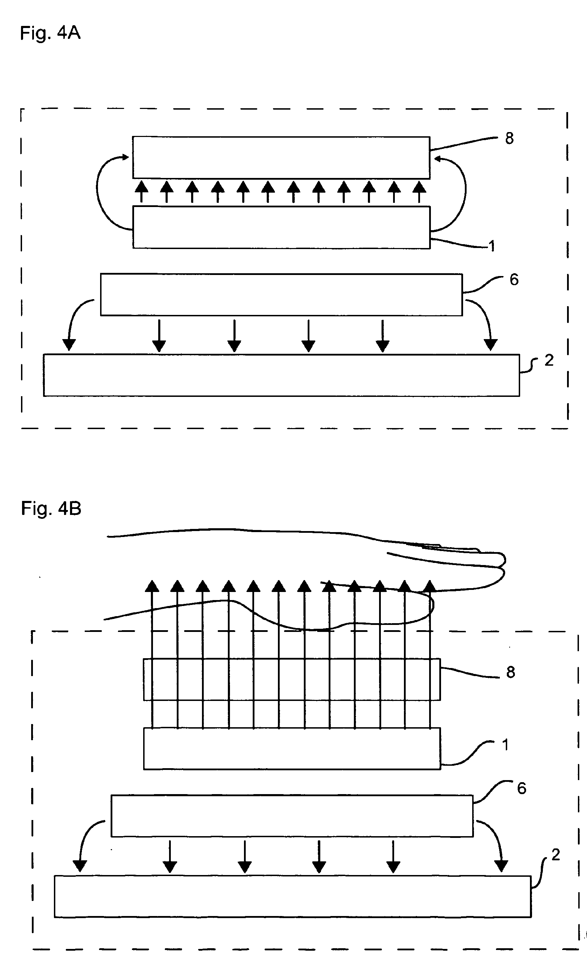

In den Figuren 4A und 4B ist schematisch eine andere Anordnung der Diagnoseelektrode 8 dargestellt. Die Diagnoseelektrode 8 überdeckt hier die Sensorelektrode 1. Im hier nicht dargestellten normalen Betriebsmodus kann die Diagnoseelektrode 8 unmittelbar mit der Sensorelektrode 1 verbunden sein. Bei dem ersten Diagnosebetriebsmodus, bei dem das Ansprechen des kapazitiven Sensors getestet wird, wird die Diagnoseelektrode 8, wie bereits beschrieben, kurzzeitig auf Masse gelegt, wobei die sich ergebende Kapazitätsänderung der Sensorelektrode 1 gegenüber Masse gemessen und ausgewertet wird.

Anhand der Figuren 4A und 4B soll ein alternatives Verfahren zum Erfassen des Aufliegens eines Objekts, insbesondere des Aufliegens einer Hand, auf dem Sensor beschrieben werden. In einer in Figur 4A dargestellten Initialisierungsphase wird die Diagnoseelektrode 8 auf Masse gelegt. Dann wird die Kapazität der Sensorelektrode 1 gegenüber Masse gemessen, die wiederum im Wesentlichen von der Kapazität zwischen der Sensorelektrode 1 und der Diagnoseelektrode 8 bestimmt wird. Die gemessene Kapazität entspricht einer Kapazität der Sensorelektrode 1 für den Fall, dass ein mit Masse verbundenes Objekt ganzflächig auf der Sensorelektrode in geringem Abstand aufliegt. Die gemessene Kapazität wird dann als Bezugswert gespeichert. Im späteren Betrieb, bei dem, wie es in Figur 4B gezeigt ist, die Diagnoseelektrode 8 sich auf einem schwebenden Potenzial befindet (sie kann auch mit der Sensorelektrode, 1 gekoppelt sein), wird nicht nur die Kapazitätsänderung sondern auch die absolute Kapazität der Sensorelektrode 1 gegenüber Masse 2 gemessen. Wenn dabei ein Kapazitätswert festgestellt wird, der nur geringfügig unter dem gespeicherten Bezugswert liegt, so kann die Ursache nur eine dicht auf der Oberfläche der Sensorelektrode 1 aufliegende Massefläche sein. Die Steuerschaltung kann dann vom Aufliegen eines mit Masse gekoppelten Objekts, beispielsweise einer Hand, ausgehen.

Beim Betrieb der erfindungsgemäßen Sensoranordnung werden der normale Betriebsmodus und die verschiedenen zuvor beschriebenen Diagnosebetriebsmodi in Abhängigkeit von der Abarbeitung einer Steuersoftware aktiviert und die Messungen ausgewertet. Auf diese Weise können regelmäßig das ordnungsgemäße Funktionieren des Sensors, die Unversehrtheit der Elektroden und/oder das (längere) Aufliegen einer Hand festgestellt werden.

## Patentansprüche

1. Kapazitive Annäherungssensoranordnung mit
wenigstens einer beabstandet zu einer Massefläche (2) angeordneten Sensorelektrode (1; 1A, 1B) und einer zwischen der wenigstens einen Sensorelektrode und der Massefläche angeordneten Schirmelektrode (6) und
einer mit der wenigstens einen Sensorelektrode, der Schirmelektrode und mit Masse verbundenen Steuerschaltung (4),
wobei die Steuerschaltung (4) dafür sorgt, dass das Potential der Schirmelektrode (6) dem Potential der wenigstens einen Sensorelektrode (1; 1A, 1B) folgt,
wobei die Steuerschaltung eine Messschaltung zum Messen der Kapazität der wenigstens einen Sensorelektrode gegenüber Masse aufweist,
wobei benachbart zu und beabstandet von der wenigstens einen Sensorelektrode sowie beabstandet von der Schirmelektrode eine Diagnoseelektrode (8) angeordnet ist, und
wobei die Steuerschaltung (4)
in einem Normalbetriebsmodus die Diagnoseelektrode (8) auf einem schwebenden Potential belässt und
in einem Diagnosebetriebsmodus ein vorgegebenes Testpotential an die Diagnoseelektrode (8) anlegt und eine sich daraus ergebende Änderung der gegenüber Masse gemessenen Kapazität der Sensorelektrode erfasst,
wobei Anschlussleitungen (3, 9) und Widerstandsbauelemente (10) derart mit der Sensorelektrode (1) und der Diagnoseelektrode (8) gekoppelt sind, dass eine mit der Steuerschaltung (4) verbundene, die Elektroden einschließende Serienschaltung gebildet wird, deren Gesamtwiderstand von der Steuerschaltung erfasst werden kann.

2. Kapazitive Annäherungssensoranordnung nach Anspruch 1, **dadurch gekennzeichnet, dass** das Testpotential Masse entspricht.

3. Kapazitive Annäherungssensoranordnung nach Anspruch 2, **dadurch gekennzeichnet, dass** die Sensorelektrode (1; 1A, 1B) wenigstens einen langgestreckten Metallstreifen umfasst und die Diagnoseelektrode (8) einen zu dem wenigstens einen langgestreckten Metallstreifen parallelen Metallstreifen umfasst.

4. Kapazitive Annäherungssensoranordnung nach Anspruch 3, **dadurch gekennzeichnet, dass** der Abstand zwischen dem Metallstreifen der Sensorelektrode und dem Metallstreifen der Diagnoseelektrode geringer ist als deren Breite.

5. Kapazitive Annäherungssensoranordnung nach Anspruch 1, **dadurch gekennzeichnet, dass** die Sensorelektrode einen langgestreckten Metallstreifen umfasst und die Diagnoseelektrode ein dazu paralleler Metallstreifen ist, wobei beide Metallstreifen in Längsrichtung in die Serienschaltung eingebunden sind.

6. Kapazitive Annäherungssensoranordnung nach Anspruch 5, **dadurch gekennzeichnet, dass** der Metallstreifen der Sensorelektrode (1) und der parallele Metallstreifen der Diagnoseelektrode (8) an einem Ende über ein Widerstandsbauelement (10) miteinander verbunden und an dem jeweils anderen Ende mit den Anschlussleitungen (3, 9) verbunden sind.

7. Kapazitive Annäherungssensoranordnung nach Anspruch 1, **dadurch gekennzeichnet, dass** die Sensorelektrode zwei parallel nebeneinander angeordnete langgestreckte Metallstreifen (1A, 1B) umfasst und die Diagnoseelektrode (8) ein dazwischen angeordneter, dazu paralleler Metallstreifen ist, wobei wenigstens zwei der drei Metallstreifen in Längsrichtung in die Serienschaltung eingebunden sind.

8. Kapazitive Annäherungssensoranordnung nach Anspruch 7, **dadurch gekennzeichnet, dass** die beiden parallelen Metallstreifen (1A, 1B) der Sensorelektrode an einem Ende über einen Widerstand (11) oder eine Kurzschlussleitung miteinander verbunden und an dem jeweils anderen Ende mit den Anschlussleitungen (3A, 3B) verbunden sind.

9. Verfahren zum Betreiben eines kapazitiven Annäherungssensors, der wenigstens eine beabstandet zu einer Massefläche angeordnete Sensorelektrode und eine zwischen der wenigstens einen Sensorelektrode und der Massefläche angeordnete Schirmelektrode aufweist und mit einer mit der wenigstens einen Sensorelektrode, der Schirmelektrode und mit Masse verbundenen Steuerschaltung gekoppelt ist,
wobei das Potential der Schirmelektrode von der Steuerschaltung dem Potential der wenigstens einen Sensorelektrode nachgeführt wird,
wobei die Kapazität der wenigstens einen Sensorelektrode gegenüber Masse von einer Messschaltung der Steuerschaltung gemessen wird,
wobei benachbart zu und beabstandet von der wenigstens einen Sensorelektrode sowie beabstandet von der Schirmelektrode eine Diagnoseelektrode angeordnet wird,
wobei in einem Normalbetriebsmodus die Diagnoseelektrode auf einem schwebenden Potential belassen wird und
in einem ersten Diagnosebetriebsmodus ein vorgegebenes Testpotential an die Diagnoseelektrode angelegt und eine sich daraus ergebende Änderung der gegenüber Masse gemessenen Kapazität der Sensorelektrode erfasst und mit einem Referenzwert verglichen wird,
wobei die Sensorelektrode beziehungsweise wenigstens eine der Sensorelektroden an zwei beabstandeten Orten mit zwei mit der Steuerschaltung gekoppelten Anschlüssen versehen wird und in einem zweiten Diagnosebetriebsmodus der Widerstand zwischen den beiden Anschlüssen überprüft wird.

10. Verfahren nach Anspruch 9, **dadurch gekennzeichnet, dass** die Diagnoseelektrode in dem ersten Diagnosebetriebsmodus mit Masse verbunden wird.

11. Verfahren nach Anspruch 9, **dadurch gekennzeichnet, dass** auch die Diagnoseelektrode an zwei beabstandeten Orten mit zwei Anschlüssen versehen wird und in dem zweiten Diagnosebetriebsmodus auch der Widerstand zwischen den beiden Anschlüssen der Diagnoseelektrode überprüft wird.

12. Verfahren nach Anspruch 11, **dadurch gekennzeichnet, dass** die Sensorelektrode beziehungsweise wenigstens eine der Sensorelektroden langgestreckt ausgebildet und an ihren Enden mit je einem Anschluss versehen wird,
dass die Diagnoseelektrode ebenfalls langgestreckt und parallel zu der Sensorelektrode ausgebildet und an ihren Enden mit je einem Anschluss versehen wird,
dass die an einem der benachbarten Enden angeordneten Anschlüsse über ein Widerstandsbauelement miteinander verbunden und die anderen beiden Anschlüsse mit der Steuerschaltung gekoppelt werden und
dass in dem zweiten Diagnosebetriebsmodus der Widerstand der Serienschaltung der Sensorelektrode, des Widerstandsbauelements und der Diagnoseelektrode überprüft wird.

13. Verfahren nach Anspruch 9, **dadurch gekennzeichnet, dass** zwei langgestreckte, parallel angeordnete Sensorelektroden an einem Ende miteinander gekoppelt werden und an ihrem anderen Ende mit jeweils einem mit der Steuerschaltung gekoppelten Anschluss versehen werden und in dem zweiten Diagnosebetriebsmodus der Widerstand zwischen den beiden Anschlüssen überprüft wird.

14. Verfahren nach Anspruch 9, **dadurch gekennzeichnet, dass** der erste Diagnosebetriebsmodus während einer Initialisierung aktiviert wird und ein Bezugswert abgespeichert wird, der der beim Anliegen des vorgegebenen Testpotentials an der Diagnoseelektrode gegenüber Masse gemessenen Kapazität der Sensorelektrode entspricht, und
dass während des nachfolgenden Betriebs der erste Diagnosebetriebsmodus wiederholt aktiviert wird, wobei dann der während der Initialisierung abgespeicherte Bezugswert mit einem Wert verglichen wird, der der beim Anliegen des vorgegebenen Testpotentials an der Diagnoseelektrode gegenüber Masse gemessenen Kapazität der Sensorelektrode entspricht, wobei bei Überschreiten einer vorgegebenen Abweichung ein ein Aufliegen eines Objekts auf dem Annäherungssensor anzeigendes Signal erzeugt wird.

## Claims

1. A capacitive proximity sensor including at least one sensor electrode (1; 1A, 1B) arranged at a spacing from an earth surface (2) and a shield electrode (6) arranged between the at least one sensor electrode and the earth surface and a control circuit (14) connected to the at least one sensor electrode, the shield electrode and to earth, wherein the control circuit (4) provides that the voltage of the shield electrode (6) follows the voltage of the at least one sensor electrode (1; 1A, 1B), wherein the control circuit includes a measurement circuit for measuring the capacitance of the at least one sensor electrode with respect to earth, wherein arranged adjacent and spaced from the at least one sensor electrode and spaced from the shield electrode there is a diagnostic electrode (8) and wherein the control circuit (4) leaves the diagnostic electrode (8) at a floating voltage, in a normal operational mode, and, in a diagnostic operational mode, applies a predetermined test voltage to the diagnostic electrode (8) and detects a change resulting therefrom in the measured capacitance of the sensor electrode with respect to earth, wherein connecting lines (3, 9) and resistive components (10) are coupled to the sensor electrode (1) and to the diagnostic electrode (8) such that a series circuit is formed which includes the electrodes and is connected to the control circuit (4) and whose total resistance can be detected by the control circuit.

2. A capacitive proximity sensor as claimed in claim 1, **characterised in that** the test voltage corresponds to earth.

3. A capacitive proximity sensor as claimed in claim 2, **characterised in that** the sensor electrode (1; 1A, 1B) includes at least one elongate metal strip and the diagnostic electrode (8) includes a metal strip parallel to the at least one elongate metal strip.

4. A capacitive proximity sensor arrangement as claimed in claim 3, **characterised in that** the distance between the metal strip of the sensor electrode and the metal strip of the diagnostic electrode is smaller than their breadth.

5. A capacitive proximity sensor as claimed in claim 1, **characterised in that** the sensor electrode includes an elongate metal strip and that the diagnostic electrode is a metal strip parallel thereto, wherein both metal strips are connected in their longitudinal direction into the series circuit.

6. A capacitive proximity sensor as claimed in claim 5, **characterised in that** the metal strip of the sensor electrode (1) and the parallel metal strip of the diagnostic electrode (8) are connected together at one end via a resistive component (10) and are connected at their other ends to the connecting lines (3,9).

7. A capacitive promiximity sensor as claimed in claim 1, **characterised in that** the sensor electrode includes two elongate metal strips (1A, 1B) arranged parallel to one another and the diagnostic electrode (8) is a metal strip parallel thereto and arranged therebetween, wherein at least two of the three metal strips are connected in their longitudinal direction into the series circuit.

8. A capacitive proximity sensor arrangement as claimed in claim 7, **characterised in that** the two parallel metal strips (1A, 1B) of the sensor electrode are connected together at one end via a resistor (11) or a short circuit and are connected at the other ends to the connecting lines (3A, 3B).

9. A method of operating a capacitive proximity sensor, which includes at least one sensor electrode arranged at a distance from an earth surface and a shield electrode arranged between the at least one sensor electrode and the earth surface and is coupled to a control circuit connected to the at least one sensor electrode, the shield electrode and to earth, wherein the voltage of the shield electrode is caused by the control circuit to follow the potential of the at least one sensor electrode, wherein the capacitance of the at least one sensor electrode with respect to earth is measured by a measurement circuit of the control circuit, wherein arranged adjacent to and spaced from the at least one sensor electrode and spaced from the shield electrode there is a diagnostic electrode, wherein the diagnostic electrode is left at a floating voltage in a normal operational mode and, in a first diagnostic operational mode, a predetermined test voltage is applied to the diagnostic electrode and a change resulting therefrom in the capacitance measured with respect to earth of the sensor electrode is detected and compared with a reference value, wherein the sensor electrode or at least one of the sensor electrodes is provided at two spaced locations with two connections coupled to the control circuit and, in a second diagnostic operational mode, the resistance between the two connections is checked.

10. A method as claimed in claim 9, **characterised in that** the diagnostic electrode is connected to earth in the first diagnostic operational mode.

11. A method as claimed in claim 9, **characterised in that** that the diagnostic electrode is also provided at two spaced locations with two connections and, in the second diagnostic operational mode, the resistance between the two connections of the diagnostic electrode is also checked.

12. A method as claimed in claim 11, **characterised in that** the sensor electrode or at least one of the sensor electrodes is of elongate construction and is provided at its ends with a respective connection, that the diagnostic electrode is also elongate and is parallel to the sensor electrode and is provided at its ends with a respective connection, that the connections arranged at one of the adjacent ends are connected together via a resistive component and the other two connections are coupled to the control circuit and that in the second diagnostic operational mode the resistance of the series circuit of the sensor electrode, of the resistive component and of the diagnostic electrode is checked.

13. A method as claimed in claim 9, **characterised in that** two elongate sensor electrodes arranged parallel to one another are coupled together at one end and at their other end are provided with a respective connection coupled to the control circuit and in the second diagnostic operational mode the resistance between the two connections is checked.

14. A method as claimed in claim 9, **characterised in that** the first diagnostic operational mode is activated during an initialisation process and a reference value is stored, which corresponds to the capacitance of the sensor electrode measured with respect to earth during the application of the predetermined test voltage to the diagnostic electrode and that during the subsequent operation the first diagnostic operational mode is again activated, wherein the reference value stored during the initialization process is then compared with a value which corresponds to the capacitance of the sensor electrode measured with respect to earth during the application of the predetermined test voltage to the diagnostic electrode, wherein when a predetermined difference is exceeded, a signal is produced indicating that an object is engaging the proximity sensor.

## Revendications

1. Agencement de capteur de proximité capacitif comprenant
au moins une électrode de capteur (1 ; 1A, 1B) disposée à distance d'une surface de masse (2) et une électrode de protection (6) disposée entre la ou les électrodes de capteur et la surface de masse et
un circuit de commande (4) relié à la ou aux électrodes de capteur, à l'électrode de protection et à la masse,
dans lequel le circuit de commande (4) veille à ce que le potentiel de l'électrode de protection (6) suive le potentiel de la ou des électrodes de capteur (1 ; 1A, 1B),
dans lequel le circuit de commande comporte un circuit de mesure pour mesurer la capacité de la ou des électrodes de capteur par rapport à la masse,
dans lequel une électrode de diagnostic (8) est disposée en position adjacente à la ou aux électrodes de capteur et à distance de celle-ci ou de celles-ci, ainsi qu'à distance de l'électrode de protection, et
dans lequel le circuit de commande (4),
dans un mode de fonctionnement normal, laisse l'électrode de diagnostic (8) à un potentiel flottant et,
dans un mode de fonctionnement de diagnostic, applique un potentiel de test préfixé à l'électrode de diagnostic (8) et détecte une variation, qui en résulte, de la capacité de l'électrode de capteur mesurée par rapport à la masse,
dans lequel des lignes de connexion (3, 9) et des composants de résistance (10) sont couplés à l'électrode de capteur (1) et à l'électrode de diagnostic (8) de façon telle qu'est formé un circuit série, relié au circuit de commande (4) et incluant les électrodes, dont la résistance totale peut être détectée par le circuit de commande.

2. Agencement de capteur de proximité capacitif suivant la revendication 1, **caractérisé en ce que** le potentiel de test correspond à la masse.

3. Agencement de capteur de proximité capacitif suivant la revendication 2, **caractérisé en ce que** l'électrode de capteur (1 ; 1A, 1B) comprend au moins une lame de métal de forme allongée et l'électrode de diagnostic (8) comprend une lame de métal parallèle à la ou aux lames de métal de forme allongée.

4. Agencement de capteur de proximité capacitif suivant la revendication 3, **caractérisé en ce que** la distance entre la lame de métal de l'électrode de capteur et la lame de métal de l'électrode de diagnostic est plus faible que leur largeur.

5. Agencement de capteur de proximité capacitif suivant la revendication 1, **caractérisé en ce que** l'électrode de capteur comprend une lame de métal de forme allongée et l'électrode de diagnostic est une lame de métal parallèle à celle-ci, les deux lames de métal étant connectées suivant la direction longitudinale dans le circuit série.

6. Agencement de capteur de proximité capacitif suivant la revendication 5, **caractérisé en ce que** la lame de métal de l'électrode de capteur (1) et la lame de métal parallèle de l'électrode de diagnostic (8) sont reliées à une extrémité entre elles par l'intermédiaire d'un composant de résistance (10) et sont reliées à l'autre extrémité respective aux lignes de connexion (3, 9).

7. Agencement de capteur de proximité capacitif suivant la revendication 1, **caractérisé en ce que** l'électrode de capteur comprend deux lames de métal (1A, 1B) de forme allongée, disposées parallèlement l'une à côté de l'autre, et l'électrode de diagnostic (8) est une lame de métal disposée entre celles-ci et parallèle à celles-ci, au moins deux des trois lames de métal étant connectées suivant la direction longitudinale dans le circuit série.

8. Agencement de capteur de proximité capacitif suivant la revendication 7, **caractérisé en ce que** les deux lames de métal (1A, 1B) parallèles de l'électrode de capteur sont reliées à une extrémité entre elles par l'intermédiaire d'une résistance (11) ou d'une ligne de court-circuit et sont reliées à l'autre extrémité respective aux lignes de connexion (3A, 3B).

9. Procédé pour faire fonctionner un agencement de capteur de proximité capacitif qui comprend au moins une électrode de capteur disposée à distance d'une surface de masse et une électrode de protection disposée entre la ou les électrodes de capteur et la surface de masse et qui est couplé à un circuit de commande relié à la ou aux électrodes de capteur, à l'électrode de protection et à la masse,
selon lequel le potentiel de l'électrode de protection est mis par le circuit de commande au potentiel de la ou des électrodes de capteur,
selon lequel la capacité de la ou des électrodes de capteur par rapport à la masse est mesurée par un circuit de mesure du circuit de commande,
selon lequel une électrode de diagnostic est disposée en position adjacente à la ou aux électrodes de capteur et à distance de celle-ci ou de celles-ci, ainsi qu'à distance de l'électrode de protection,
selon lequel dans un mode de fonctionnement normal, l'électrode de diagnostic est laissée à un potentiel flottant et,
dans un premier mode de fonctionnement de diagnostic, un potentiel de test préfixé est appliqué à l'électrode de diagnostic et une variation, qui en résulte, de la capacité de l'électrode de capteur mesurée par rapport à la masse est détectée et est comparée à une valeur de référence,
selon lequel l'électrode de capteur ou respectivement au moins l'une des électrodes de capteur est pourvue, en deux emplacements espacés, de deux connexions couplées au circuit de commande et, dans un second mode de fonctionnement de diagnostic, la résistance entre les deux connexions est contrôlée.

10. Procédé suivant la revendication 9, **caractérisé en ce que** l'électrode de diagnostic est, dans le premier mode de fonctionnement de diagnostic, reliée à la masse.

11. Procédé suivant la revendication 9, **caractérisé en ce qu'**également l'électrode de diagnostic est pourvue, en deux emplacements espacés, de deux connexions et **en ce que**, dans le second mode de fonctionnement de diagnostic, également la résistance entre les deux connexions de l'électrode de diagnostic est contrôlée.

12. Procédé suivant la revendication 11, **caractérisé**
**en ce que** l'électrode de capteur ou respectivement au moins l'une des électrodes de capteur est réalisée de forme allongée et est pourvue, à ses extrémités, d'une connexion respective,
**en ce que** l'électrode de diagnostic est réalisée également de forme allongée et parallèle à l'électrode de capteur et est pourvue, à ses extrémités, d'une connexion respective,
**en ce que** les connexions disposées à l'une des extrémités adjacentes sont reliées entre elles, par l'intermédiaire d'un composant de résistance, et les deux autres connexions sont couplées au circuit de commande et
**en ce que**, dans le second mode de fonctionnement de diagnostic, la résistance du circuit série de l'électrode de capteur, du composant de résistance et de l'électrode de diagnostic est contrôlée.

13. Procédé suivant la revendication 9, **caractérisé en ce que** deux électrodes de capteur de forme allongée et disposées en parallèle sont couplées à une première extrémité entre elles et, à leur autre extrémité, sont pourvues respectivement d'une connexion couplée au circuit de commande et **en ce que**, dans le second mode de diagnostic, la résistance entre les deux connexions est contrôlée.

14. Procédé suivant la revendication 9, **caractérisé**
**en ce que** le premier mode de fonctionnement de diagnostic est activé pendant une initialisation et une valeur de référence est mise en mémoire, laquelle valeur de référence correspond à la capacité de l'électrode de capteur qui est mesurée par rapport à la masse lors de l'application du potentiel de test préfixé à l'électrode de diagnostic, et
**en ce que**, pendant le fonctionnement qui suit, le premier mode de fonctionnement de diagnostic est activé de manière répétée, en ce qu'alors la valeur de référence mise en mémoire pendant l'initialisation est comparée à une valeur qui correspond à la capacité de l'électrode de capteur mesurée par rapport à la masse lors de l'application du potentiel de test préfixé à l'électrode de diagnostic, et en ce que, en cas de dépassement d'un écart préfixé, un signal est produit qui indique l'application d'un objet sur le capteur de proximité.
